Europäisches Patentamt

European Patent Office

Office européen des brevets

(11) Veröffentlichungsnummer: **0 427 164 A2**

(12) **EUROPÄISCHE PATENTANMELDUNG**

(21) Anmeldenummer: 90121109.4

(51) Int. Cl.⁵: **H04B 1/10**

(22) Anmeldetag: **05.11.90**

(30) Priorität: 06.11.89 DE 3936888

(43) Veröffentlichungstag der Anmeldung:
**15.05.91 Patentblatt 91/20**

(84) Benannte Vertragsstaaten:
**AT BE CH DE DK ES FR GB GR IT LI LU NL SE**

(71) Anmelder: **STABO ELEKTRONIK GMBH & CO. KG**
**Münchewiese 16**
**W-3200 Hildesheim(DE)**

(72) Erfinder: **Semmer, Horst**
**Stollenweg 11**
**W-3000 Hannover 91(DE)**
Erfinder: **Kukulady, Manfred**
**Hagenstrasse 23**
**W-3410 Northeim(DE)**
Erfinder: **Kasalowsky, Wolfgang**
**In den Heidlandsfuhren 9**
**W-3031 Lindwedel(DE)**
Erfinder: **Welling, Hans**
**Bahnhofstrasse 22**
**W-3201 Hoheneggelsen(DE)**

(74) Vertreter: **Eisenführ, Speiser & Strasse**
**Martinistrasse 24**
**W-2800 Bremen 1(DE)**

(54) **Rauschverminderungsschaltung für einen Frequenzmodulationsempfänger.**

(57) Ein Frequenzmodulationsempfänger weist eine Rauschverminderungsschaltung (6) auf, welche ein Dämpfungsglied (14) enthält, das die Lautstärke des Niederfrequenzsignales (NF) in Abhängigkeit von der Empfangsfeldstärke des Hochfrequenzsignales (HF) zwischen einem Maximalwert und einem Minimalwert kontinuierlich steuert.

Fig. 1

# RAUSCHVERMINDERUNGSSCHALTUNG FÜR EINEN FREQUENZMODULATIONSEMPFÄNGER

Die Erfindung betrifft eine Rauschverminderungsschaltung für einen Frequenzmodulationsempfänger mit einem Empfangsteil, das ein über eine Antenne empfangenes frequenzmoduliertes Hochfrequenzsignal entsprechend der Frequenzmodulation in ein Niederfrequenzsignal umwandelt.

FM-Empfänger haben die Eigenschaft, stark zu rauschen, wenn kein oder nur ein schwaches Empfangssig nal vorhanden ist. Um dieses unangenehme Rauschen zu unterdrücken, wurden bisher Rauschverminderungsschaltungen verwendet, welche als Squelch-Schaltungen arbeiten. Die wesentliche Eigenschaft der Squelch-Schaltung besteht darin, daß das Niederfrequenzsignal unterhalb eines bestimmten, die Ansprechschwelle bildenden Wertes der Empfangsfeldstärke gesperrt und oberhalb dieses Wertes übertragen wird. Üblicherweise kann die Ansprechschwelle wahlweise auf einen gewünschten Wert eingestellt werden. Die herkömmlichen Squelch-Schaltungen können nur die beiden Zustände "Empfänger stumm geschaltet" bei einer Empfangsfeldstärke unterhalb der Ansprechschwelle oder "Empfänger laut geschaltet" bei einer Empfangsfeldstärke oberhalb der Ansprechschwelle erzeugen. Speziell im Mobilbetrieb führt diese Eigenschaft des Squelch-Schaltung bei einer Empfangsfeldstärke, die mit ihrem Wert im Bereich der Ansprechschwelle lag, zu der Ungewißheit, ob die Empfangsfeldstärke von der Gegenstation gerade unterhalb der Ansprechschwelle liegt oder ob die Gegenstation tatsächlich nicht sendet. Außerdem ergibt sich bei schwankender Empfangsfeldstärke ein unangenehmes An- und Abschalten, was insbesondere während des laufenden Funkbetriebes äußerst störend ist.

Es sind zwar Schaltungen für die Verminderung des Rauschens bekannt, die anstelle oder zusätzlich zu der zuvor beschriebenen Squelch-Schaltung verwendet werden können; obwohl derartige Schaltungen einen erheblichen Aufwand an Bauelementen erfordern, arbeiten sie nicht zufriedenstellend.

Aufgabe der Erfindung ist es daher, eine Rauschverminderungsschaltung der eingangs genannten Art unter geringem Aufwand derart weiterzuwentwickeln, daß die zuvor beschriebenen Nachteile des Standes der Technik vermieden werden und insbesondere bei schwankender Empfangsfeldstärke kein unangenehmes An- und Abschalten des Niederfrequenzsignals auftritt.

Diese Aufgabe wird durch die Verwendung eines Dämpfungsgliedes gelöst, das die Lautstärke des Niederfrequenzsignals in Abhängigkeit von der Empfangsfeldstärke zwischen einem Maximalwert und einem Minimalwert kontinuierlich steuert.

Das erfindungsgemäße Dämpfungsglied bewirkt in Abhängigkeit von der Empfangsfeldstärke eine Verminderung der Lautstärke des Niederfrequenzsignals und somit auch des störenden Rauschens. Es findet jedoch im Gegensatz zu den im Stand der Technik verwendeten Squelch-Schaltungen keine Stummschaltung des Empfängers statt, sondern lediglich eine Lautstärkeverminderung. Dabei ist der Übergang vom Maximalwert der Lautstärke des Niederfrequenzsignals zum Minimalwert, also vom lauten zum leisen Zustand, durch die erfindungsgemäß vorgesehene kontinuierliche Regelung fließend. Der FM-Empfänger benimmt sich also ähnlich wie ein AM-Empfänger. Die erfindungsgemäße Lautstärkeverminderung bei schwachen Empfangsfeldstärken bietet den Vorteil, daß der hohe Rauschanteil nicht so stark wahrgenommen wird, wie dies bei unverminderter Lautstärke der Fall wäre, und daß das Nutzsignal somit subjektiv besser verständlich erscheint.

Vorzugsweise steuert das Dämpfungsglied die Lautstärke des Niederfrequenzsignals proportional zur Empfangsfeldstärke, wodurch sich ein angenehmer subjektiver Eindruck bei der Lautstärkeverminderung ergibt.

Bei einer weiteren Ausgestaltung der Erfindung ist an das Dämpfungsglied ein erstes Einstellglied zur Einstellung des Minimalwertes der Lautstärke des Niederfrequenzsignals angeschlossen, womit die maximale Abschwächung des Niederfrequenzsignals in der gewünschten Höhe eingestellt werden kann.

Gemäß einer weiteren zweckmäßigen Ausführungsform stellt das Dämpfungsglied die Lautstärke des Niederfrequenzsignales oberhalb eines vorgegebenen Ansprechschwellwertes der Empfangsfeldstärke auf den Maximalwert ein und beginnt es unterhalb des Ansprechschwellwertes abzuschwächen. Somit kann der Gewinn der Lautstärkeverminderung der Empfangslage angepaßt werden.

Bei dieser Ausführungsform ist vorzugsweise an das Dämpfungsglied ein zweites Einstellglied zur Einstellung des Ansprechschwellwertes angeschlossen.

Eine besonders zweckmäßige Ausführung der Erfindung mit einem Niederfrequenzeingang zur Eingabe des Niederfrequenzsignals vom Empfangsteil, mit einem Niederfrequenzausgang zur Ausgabe des geregelten Niederfrequenzsignals an einen Lautsprecher und mit Regelspannungseingang zur Eingabe einer vom Empfangsteil in Abhängigkeit von der Empfangsfeldstärke erzeugten Regelspannung ist dadurch gekennzeichnet, daß das Dämpfungsglied einen zwischen Niederfrequenzeingang und Niederfrequenzausgang geschalteten ersten Widerstand und einen Transistor enthält, der mit seiner Basis an den Regelspannungseingang und mit seiner Kollektor-Emitter-Strecke zwischen dem Niederfrequenzausgang und der Masse so geschaltet ist, daß die Kollektor-Emitter-Strecke mit steigender Empfangsfeldstärke hochohmiger wird. Die Erfindung ist mit dieser Schaltung besonders einfach und ohne großen Aufwand zu verwirklichen, da als Dämpfungsglied im wesentlichen nur der Transistor verwendet wird, dessen Kollektor-Emitter-Strecke zusammen mit dem Widerstand einen Spannungsteiler bildet. Je hochohmiger die Kollektor-Emitter-Strecke mit steigender Empfangsfeldstärke wird, desto ungeschwächter wird das Niederfrequenzsignal übertragen und desto lauter ist es.

Bei einer zweckmäßigen Weiterbildung dieser Ausführungsform ist in die den Niederfreqzuenzausgang über die Kollektor-Emitter-Strecke des Transitors mit der Masse verbindende Leitung ein zweiter Widerstand geschaltet. Ohne diesen zweiten Widerstand würde nämlich die Lautstärke des Niederfrequenzsignals auf Null verringert werden, wenn der Transistor vollständig durchgeschaltet, also dessen Kollektor-Emitter-Strecke vollständig leitend ist, da dann der Niederfrequenzausgang mit Masse kurzgeschlossen ist. Demgegenüber bewirkt der zweite Widerstand auch bei vollständigem Durchschalten des Transistors einen Spannungsabfall zwischen Niederfrequenzausgang und Masse und verhindert somit einen Kurzschluß, wodurch die Lautstärke des Niederfrequenzsignals nicht vollständig auf Null, sondern nur auf einen Minimalwert größer Null reduziert wird. Somit wird der Empfänger nicht vollständig abgeschaltet, sondern in einen leisen Zustand geschaltet. Mit Hilfe dieses zweiten Widerstandes wird also eine Dämpfung der Lautstärke des Niederfrequenzsignals erzeugt, jedoch kein vollständiges Stummschalten.

Vorzugsweise ist der zweite Widerstand zur Einstellung des Minimalwertes bzw. der maximalen Dämpfung der Lautstärke des Niederfrequenzsignals ein Potentiometer.

Eine weitere vorteilhafte Weiterbildung dieser Ausführung zeichnet sich dadurch aus, daß die Regelspannung eine zur Empfangsfeldstärke proportionale positive Gleichspannung ist und der Transistor ein pnp-Transistor ist und mit seinem Emitter über einen dritten Widerstand an einem Referenzspannungseingang, an dem eine konstante positive Gleichspannung anliegt, und über einen vierten Widerstand an Masse angeschlossen ist. Der dritte und der vierte Widerstand bilden einen Spannungsteiler, durch den der Emitter des Transistors auf eine Ansprechspannung angehoben wird, die positiver als die an der Basis anliegende Regelspannung bei kleinen Empfangsfeldstärken ist. Dies hat zur Folge, daß bei kleinen Empfangsfeldstärken und somit geringer Regelspannung die Kollektor-Emitter-Strecke des Transistors durchgeschaltet und somit die Lautstärke des Niederfrequenzsignals entsprechend verringert ist. Steigt dagegen die Regelspannung an, so wird die Kollektor-Emitter-Strecke hochohmiger, bis der Transistor sperrt, wenn die Regelspannung an der Basis höher als die Ansprechspannung am Emitter ist. Die Ansprechspannung am Emitter erzeugt somit eine Ansprechschwelle, unterhalb derer die Lautstärke des Niederfrequenzsignals auf einen Minimalwert, ggf. Null, reduziert ist und oberhalb derer die Lautstärke des Niederfrequenzsignals proportional zur Regelspannung auf den maximalen Wert ansteigt.

Zur Einstellung des Ansprechschwellwertes ist vorzugsweise der vierte Widerstand ein Potentiometer.

Die Erfindung wird nachstehend anhand des in den Zeichnungen dargestellten Ausführungsbeispiels näher erläutert. Es zeigen:

Fig. 1 ein Blockschaltbild eines FM-Empfängers; und

Fig. 2 den Aufbau einer im FM-Empfänger gemäß Figur 1 verwendeten Rauschverminderungsschaltung.

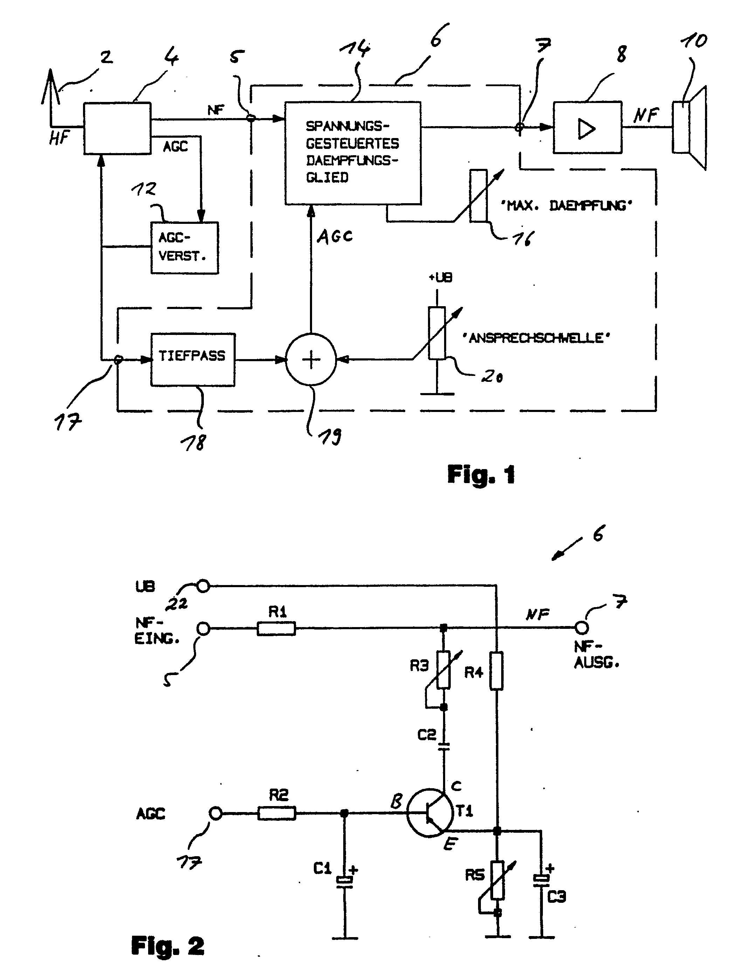

Figur 1 zeigt das Blockschaltbild eines FM-Empfängers. Über eine Antenne 2 werden frequenzmodulierte Hochfrequenzsignale HF empfangen und einem Empfangsteil 4 zugeführt. Im Empfangsteil 4 werden die Hochfrequenzsignale HF entsprechend der Frequenzmodulation in Niederfrequenzsignale NF umgewandelt und einem Niederfrequenzeingang 5 einer Rauschverminderungsschaltung 6 zugeführt. Die Rauschverminderungsschaltung 6 ist in Figur 1 als gestrichelter Kasten dargestellt. Von einem Niederfrequenzausgang 7 der Rauschverminderungsschaltung 6 wird das Niederfrequenzsignal NF über einen Verstärker 8 einem Lautsprecher 10 zugeführt.

Zusätzlich zum Niederfrequenzsignal NF erzeugt das Empfangsteil 4 noch eine Regelspannung AGC, die aus einer positiven Gleichspannung bestehen kann und proportional zu der Empfangsfeldstärke des empfangenen Hochfrequenzsignals HF ist. Die Regelspannung AGC wird in einem AGC-Verstärker 12 verstärkt und dem Empfangsteil 4 sowie über einen Regelspannungseingang 17 der Rauschverminderungsschaltung 6 zugeführt.

Zwischen Niederfrequenzeingang 5 und Niederfrequenzausgang 7 ist innerhalb der Rauschverminderungsschaltung 6 ein spannungsgesteuertes Dämpfungsglied 14 geschaltet. An dem Dämpfungsglied 14 ist ein Einstellglied 16 zur Einstellung der maximalen Dämpfung des Niederfrequenzsignals NF angeschlossen.

Vom Regelspannungseingang 17 wird die Regelspannung AGC über einen Tiefpass 18 dem Dämpfungsglied zugeführt. Zwischen Tiefpass 18 und Dämpfungsglied 14 ist ein Knotenpunkt 19 vorgesehen, an den ein Einstellglied 20 zur Einstellung eines Ansprechschwellwertes der Regelspannung AGC angeschlossen ist.

In Abhängigkeit von der Regelspannung AGC steuert nun das Dämpfungsglied 14 die Lautstärke des Niederfrequenzsignals NF kontinuierlich zwischen einem Maximalwert und einem Minimalwert. Gewöhnlicherweise wird das Niederfrequenzsignal NF bei Regelung auf den Maximalwert ohne Verlust an den Lautsprecher 10 übertragen. Der Minimalwert ist mit Hilfe des Einstellgliedes 16 einstellbar, und zwar in der Regel zwischen Null und einem darüber liegenden Wert. Zweckmäßig ist es, wenn die Regelspannung AGC proportional zu der Empfangsfeldstärke des Hochfrequenzsignals HF ist; dies ist jedoch nicht unbedingt notwendig.

Unterhalb eines bestimmten Empfangsfeldstärkenwertes beginnt das Dämpfungsglied 14 das Niederfrequenzsignal NF abzuschwächen. Dieser Empfangsfeldstärkenwert bildet einen Ansprechschwellwert und liegt in niedrigen Bereichen der Empfangsfeldstärke. Der Ansprechschwellwert ist mit Hilfe des Einstellreglers 20 einstellbar.

Figur 2 zeigt einen konkreten Aufbau der Rauschverminderungsschaltung 6. Zwischen dem Niederfrequenzeingang 5 und dem Niederfrequenzausgang 7 ist ein Widerstand R1 geschaltet. An diesen Widerstand R1 ist ausgangsseitig ein Potentiometer R3 angeschlossen, der über einen Trennkondensator C2 mit dem Kollektor C eines pnp-Transistors T1 verbunden ist. Der Regelspannungseingang 17 ist über einen aus einem Widerstand R2 und einem Kondensator C1 bestehenden Tiefpass an die Basis B des Transistors T1 angeschlossen. Der Emitter E des Transistors T1 ist sowohl über einen Widerstand R4 mit einem Referenzspannungseingang 22, an dem eine konstante positive Gleichspannung UB anliegt, als auch über ein Potentiometer R5 und einem hierzu parallel geschalteten Kondensator C3 mit Masse verbunden.

Da das Potentiometer R5 vom Kondensator C3 wechselspannungsmäßig überbrückt wird, bilden im Niederfrequenzzweig der Widerstand R1 und die Reihenschaltung aus dem Potentiometer R3 und der Kollektor-Emitter-Strecke CE des Transistors T1 einen Wechselspannungsteiler für das Niederfrequenzsignal NF.

Die Kollektor-EmitterStrecke CE des Transistors T1 bildet dabei einen variablen Widerstand. Die Widerstände R4 und R5 bilden einen Gleichspannungsteiler, wodurch die Spannung am Emitter E entsprechend dem Verhältnis beider Widerstandswerte gegenüber der Referenzspannung UB herabgesetzt wird.

Für die in Figur 2 dargestellte Schaltung ist die Regelspannung AGC proportional zur Empfangsfeldstärke. Ist die Regelspannung gegenüber der Spannung am Emitter E um mindestens der erforderlichen Basis-Emitter-Spannung negativer, so schaltet der Transistor T1 durch, und die Kollektor-Emitter-Strecke CE ist niederohmig. In diesem Zustand wird das Niederfrequenzsignal NF am stärksten abgeschwächt. Die maximale Abschwächung des Niederfrequenzsignals NF ist dabei mit Hilfe des Potentiometers R3 einstellbar. Wird nun die Differenz zwischen der an der Basis B anliegenden Regelspannung AGC und der Emitterspannung kleiner als die für das Durchschalten des Transistors T1 benötigte Mindest-Basis-Emitter-Spannung und steigt die Regelspannung AGC weiter an, so wird die Kollektor-Emitter-Strecke CE des Transistors T1 zunehmend hochohmiger. Dies hat zur Folge, daß das Niederfrequenzsignal NF am Niederfrequenzausgang 7 lauter wird. Die Emitterspannung bildet somit eine Ansprechschwellspannung, deren Höhe mit Hilfe des Potentiometers R5 einstellbar ist.

Der Vergleich zwischen den Figuren 1 und 2 läßt erkennen, daß das Dämpfungsglied 14 im wesentlichen aus dem Widerstand R1 und dem Transistor T1, der Einstellregler 16 aus dem regelbaren Widerstand R3, der Tiefpass 18 aus dem Widerstand R2 und dem Kondensator C1 und der Einstellregler 20 aus den Wider ständen R4 und R5 gebildet wird.

Schließlich ist noch anzumerken, daß das Potentiometer R3 auch weggelassen werden und R5 auch konstant sein kann. Auf den Spannungsteiler R4/R5 kann auch verzichtet werden, wenn die Referenzspannung in der benötigten Höhe direkt an den Emitter E von T1 angelegt wird.

Schließlich ist noch darauf hinzuweisen, daß die Lautstärkeverminderung zu sehr niedrigen Lautstärken führen kann, welche kaum noch hörbar wären, so daß in diesen Fällen eine Stummschaltung zweckmäßiger sein kann. Bei einer solchen Ausführung wird somit die Funktion der herkömmlichen Squelch-Schaltung, nämlich das Stummschalten des Empfängers, in die erfindungsgemäße Rauschverminderungsschaltung integriert. Dies hat sich insbesondere beim Einsatz der Rauschverminderungsschaltung in Funkgeräten als sinnvoll und nützlich herausgestellt.

## Ansprüche

1. Rauschverminderungsschaltung für einen Frequenzmodulationsempfänger mit einem Empfangsteil (4), das ein über eine Antenne (2) empfangenes frequenzmoduliertes Hochfrequenzsignal (HF) entsprechend der Frequenzmodulation in ein Niederfrequenzsignal (NF) umwandelt,

gekennzeichnet durch ein Dämpfungsglied (14), das die Lautstärke des Niederfrequenzsignals (NF) in Abhängigkeit von der Empfangsfeldstärke zwischen einem Maximalwert und einem Minimalwert kontinuierlich steuert.

2. Rauschverminderungsschaltung nach Anspruch 1, dadurch gekennzeichnet, daß das Dämpfungsglied (14) die Lautstärke des Niederfrequenzsignals (NF) proportional zur Empfangsfeldstärke steuert.

3. Rauschverminderungsschaltung nach Anspruch 1 oder 2, dadurch gekennzeichnet, daß an das Dämpfungsglied (14) ein erstes Einstellglied (16) zur Einstellung des Minimalwertes der Lautstärke des Niederfrequenzsignals (NF) angeschlossen ist.

4. Rauschverminderungsschaltung nach einem der Ansprüche 1 bis 3, dadurch gekennzeichnet, daß das Dämpfungsglied (14) die Lautstärke des Niederfrequenzsignales (NF) oberhalb eines vorgegebenen Ansprechschwellwertes der Empfangsfeldstärke auf den Maximalwert einstellt und unterhalb des Ansprechschwellwertes abzuschwächen beginnt.

5. Rauschverminderungsschaltung nach Anspruch 4, dadurch gekennzeichnet, daß an das Dämpfungsglied (14) ein zweites Einstellglied (20) zur Einstellung des Ansprechschwellwertes angeschlossen ist.

6. Rauschverminderungsschaltung nach einem der Ansprüche 1 bis 5, mit einem Niederfrequenzeingang (5) zur Eingabe des Niederfrequenzsignals (NF) vom Empfangsteil (4), mit einem Niederfrequenzausgang (7) zur Ausgabe des geregelten Niederfrequenzsignals an einen Lautsprecher (10) und mit einem Regelspannungseingang (17) zur Eingabe einer vom Empfangsteil (4) in Abhängigkeit von der Empfangsfeldstärke erzeugten Regelspannung (AGC), dadurch gekennzeichnet, daß das Dämpfungsglied (14) einen zwischen Niederfrequenzeingang (5) und Niederfrequenzausgang (7) geschalteten ersten Widerstand (R1) und einen Transistor (T1) enthält, der mit seiner Basis (B) an den Regelspannungseingang (17) und mit seiner Kollektor-Emitter-Strecke (CE) zwischen dem Niederfrequenzausgang (7) und der Masse so geschaltet ist, daß die Kollektor-Emitter-Strecke (CE) mit steigender Empfangsfeldstärke hochohmiger wird.

7. Rauschverminderungsschaltung nach Anspruch 6, dadurch gekennzeichnet, daß in die den Niederfrequenzausgang (7) über die Kollektor-Emitter-Strecke (CE) des Transistors (T1) mit der Masse verbindende Leitung ein zweiter Widerstand (R3) geschaltet ist.

8. Rauschverminderungsschaltung nach Anspruch 3 und 7, dadurch gekennzeichnet, daß der zweite Widerstand (R3) zur Einstellung des Minimalwertes der Lautstärke des Niederfrequenzsignales (NF) ein Potentiometer ist.

9. Rauschverminderungsschaltung nach einem der Ansprüche 6 bis 8, dadurch gekennzeichnet, daß die Regelspannung (AGC) eine zur Empfangsfeldstärke proportionale positive Gleichspannung ist und der Transistor (T1) ein pnp-Transistor ist und mit seinem Emitter (E) über einen dritten Widerstand (R4) an einem Referenzspannungseingang (22), an dem eine konstante positive Gleichspannung (UB) anliegt, und über einen vierten Widerstand (R5) an Masse angeschlossen ist.

10. Rauschverminderungsschaltung nach Anspruch 5 und 9, dadurch gekennzeichnet, daß der vierte Widerstand (R5) zur Einstellung des Ansprechschwellwertes ein Potentiometer ist.

**Fig. 1**

**Fig. 2**